Europäisches Patentamt

(19) European Patent Office

Office européen des brevets

(11) Publication number: **0 215 175**
**B1**

# EUROPEAN PATENT SPECIFICATION

(45) Date of publication of the patent specification:
04.04.90

(51) Int. Cl.⁴: **H05K 3/38**

(21) Application number: **85401770.4**

(22) Date of filing: **12.09.85**

(54) A copper-foiled flexible base for printed circuit board.

(43) Date of publication of application:
25.03.87 Bulletin 87/13

(45) Publication of the grant of the patent:
04.04.90 Bulletin 90/14

(84) Designated Contracting States:
DE FR GB

(56) References cited:
EP-A- 0 124 847
DE-B- 2 320 099
DE-B- 2 702 283
US-A- 3 801 427

(73) Proprietor: Shin-Etsu Chemical Co., Ltd., 6-1,
Ohtemachi 2-chome, Chiyoda-ku Tokyo 100(JP)

(72) Inventor: Iida, Tamaki, 1-202, Hanakoganei Green
Heights 3-8-43 Minami-cho, Higashikurumei-shi
Tokyo(JP)
Inventor: Kitamura, Hajime, 6-14-2, Aobadai, Ichihara-shi
Chiba-ken(JP)
Inventor: Inoue, Kaname, 5-18-10-404, Arima
Miyamae-ku, Kawasaki-shi Kanagawa-ken(JP)

(74) Representative: Armengaud Ainé, Alain et al, Cabinet
ARMENGAUD AINE 3 Avenue Bugeaud,
F-75116 Paris(FR)

## Description

## BACKGROUND OF THE INVENTION

The present invention relates to a copper-foiled flexible base board for printed circuit BOARD or, more particularly, to a copper-foiled flexible base board for printed circuit board having excellent adhesive bonding strength between the copper foil and the base board.

As is known, an increasing proportion of printed circuit boards in recent years are prepared using a flexible copper-foiled base board and flexible copper-foiled printed circuit boards are required more and more to withstand many times of repeated bending in use. Accordingly, it is eagerly desired to develop a copper-foiled base board for printed circuit board having good flexibility and a high adhesive bonding strength between the copper foil and the base board to which the copper foil is bonded.

Conventional copper-foiled flexible base boards for printed circuit board in the prior art are mostly prepared by directly bonding an electrolytic or rolled copper foil to the surface of a film of a plastic resin such as polyesters, polyimides and the like using an adhesive. The copper-foiled flexible base board prepared in this manner has a problem in respect of adhesive bonding that the type of usable adhesive is limited and no sufficient adhesive bonding strength can be obtained between the copper foil and the base board even by use of an adhesive known to give the highest adhesive bonding strength.

Indeed, the inventors have conducted investigations on the manufacturing process of copper-foiled flexible base boards for printed circuit board of the additive type using a plastic film of a polyester, polyimide and the like only to know that it is extremely difficult to obtain an adhesive bonding strength of 2.3 kg/cm or larger between the copper foil and the base board and the adhesive bonding strength can hardly be maintained in the repeated bending test.

A method for the preparation of a flexible base for printed circuit board composed of a flexible sheet-like base and a metal foil adhesively bonded to the base by means of an adhesive which comprises treating the surface of the base and integrally bonding the metal foil to the thus treated surface of the base with a layer of an adhesive intervening therebetween is known from EP-A 124 847.

## SUMMARY OF THE INVENTION

An object of the present invention is therefore to provide a process for making a novel and improved copper-foiled flexible base board for printed circuit board having excellent adhesive bonding strength between the copper foil and the base as the substrate to which the copper foil is adhesively bonded so as to be able to withstand many times of repeated bending test.

Consequently, the invention process comprises the steps of:

– subjecting one surface of a base plastic film having flexibility to a surface roughening treatment by honing using a liquid dispersion of an abrasive powder and,

– coating said roughened surface with a copper foil and an intervening layer of an adhesive for adhesively and integrally bonding said copper-foil to said roughened surface with said adhesive layer therebetween.

In particular, it has been established that the best results of adhesive bonding between the copper foil and the plastic film can be obtained when the microscopic cavities or pits formed on the surface of the plastic film by honing with an abrasive powder have a depth in the range from 1 to 5 µm and a width in the range from 0.5 to 2 µm at a half depth thereof.

## DETAILED DESCRIPTION OF THE PREFERRED EMBODIMENTS

According to the present invention summarized above, the copper-foiled flexible base for printed circuit board is imparted with a greatly increased adhesive bonding strength between the copper foil and the base of a plastic film and hence with remarkably improved resistance against bending by virtue of the greatly increased surface area as a result of the surface roughening of the film and the anchoring effect of the microcavities or pits formed by the honing treatment for the adhesive.

The base film of the inventive copper-foiled flexible base for printed circuit board should be a film of a plastic resin having flexibility and high heat resistance such as polyesters, polyimides and the like conventionally used in copper-foiled flexible bases for printed circuit board. The film should have a thickness in the range from about 12 to about 125 µm though not particularly limited thereto.

The base film is subjected to the surface roughening treatment by honing using a liquid dispersion of an abrasive powder. The apparatus for honing may be a conventional one for liquid honing equipped with a liquid supply tank and a pressurized jet nozzle. The liquid abrasive dispersion is prepared by dispersing a fine abrasive powder such as alumina, silicon carbide, emery, fine glass beads and the like in water by use of a surface active agent. The particle size of the abrasive powder should preferably be in the range from #280 to #500 according to the definition specified in JIS and the surface active agent is used usually in a concentration of about 3 % by weight in water.

In practicing the surface roughening treatment of the base film, the liquid tank of the honing apparatus is filled with the liquid dispersion of an abrasive prepared in the above described formulation and pressurized by means of a compressor to have a hydraulic pressure of 2 kg/cm²G or, if necessary, higher. The thus pressurized liquid abrasive dispersion is blown in a jet through the jet nozzle against the surface of the film under running so that the surface of the film is roughened. This honing treatment may be performed either continuously or in a batch-wise manner. The film after completion of the honing treatment is then washed with water, preferably, under pressurization followed by drying in a stream of hot air or other suitable means. The conditions of the honing treatment should be controlled so that the base film having a roughened surface after the honing treatment is provided with microcavities or pits having a depth in the range from about 1 to about 5 μm and a width at a one-half depth, referred to as a median width hereinbelow, in the range from about 0.5 to 2 μm.

The inventive copper-foiled flexible base for printed circuit board is prepared by adhesively and integrally bonding a copper foil to the thus roughened surface of the base film. The copper foil may be an electrolytic copper foil or a rolled copper foil having a thickness in the range from about 25 to about 125 μm. The adhesive used in this case may be a conventional one mainly composed of an epoxy resin, phenolic resin and the like selected with consideration of the compatibility or affinity with the base film. The adhesive is uniformly applied to the surface of the base film roughened by the honing treatment in a thickness of 10 to 25 μm and the copper foil is laid thereon and bonded together under pressure so as to give an inventive copper-foiled flexible base for printed circuit board.

In the following, the copper-foiled flexible base for printed circuit board of the invention is described in more detail by way of examples.

Example 1.

A polyester film having a thickness of 0.1 mm was cut into cut sheets each of dimensions of 300 mm by 600 mm and each of the cut sheets was subjected to a honing treatment in a batch-wise manner. Namely, the cut sheet was set in a liquid honing apparatus and the abrasive liquid in the liquid holder tank of the apparatus prepared by dispersing a #300 emery powder containing 3 % of a surface active agent in water was pressurized up to a pressure of 2 kg/cm²G by running the compressor. Then, the abrasive liquid was ejected out of the nozzle by opening the valve and blown at the surface of the polyester sheet under movement which was then washed with pressurized water and dried in a stream of hot air.

The polyester sheet after the honing treatment in the above described manner had a roughened surface of which the microcavities or pits each had a depth of about 2 μm and a median width of about 0.7 μm.

The thus roughened surface of the polyester sheet was coated with an epoxy-based adhesive and an electrolytic copper foil having a thickness of 35 μm was bonded thereto to give a copper-foiled flexible base for printed circuit board, of which the adhesive bonding strength between the polyester sheet and the copper foil was determined to give a value of 2.9 kg/cm. This value of the adhesive bonding strength was retained without decrease even after 1000 times repetition of bending at a bending curvature of 5 mm radius.

Comparative Example.

A copper-foiled flexible base for printed circuit board was prepared in the same manner as in Example 1 excepting the omission of the honing treatment with the abrasive liquid dispersion of the emery powder. The adhesive bonding strength between the polyester sheet and the copper foil was only 1.7 kg/cm. In the bending test, bulging was found at portions after 500 times of repeated bending with a decrease of the adhesive bonding strength to 0.8 kg/cm. When the bending test was further continued, the copper foil became broken after 650 times of repeated bending.

Example 2.

A polyester film of 300 mm width having a thickness of 0.1 mm in a roll was subjected to a continuous honing treatment. The procedure for the honing treatment was substantially the same as in Example 1 except that the polyester film was moved continuously and the abrasive liquid was an aqueous dispersion of a #320 alumina abrasive powder containing 3 % of a surface active agent. The thus roughened surface of the polyester film had microcavities or pits each having a depth of about 27 μm and a median width of about 0.7 μm.

An electrolytic copper foil having a thickness of 35 μm was adhesively bonded to the thus roughened surface of the polyester film by use of a phenolic adhesive to give a copper-foiled flexible base for printed circuit board, of which the adhesive bonding strength between the polyester film and the copper foil was 2.8 kg/cm. This value of the adhesive bonding strength was retained without decrease even after 1000 times of repeated bending test undertaken in the same manner as in Example 1.

Claims

1. A process for making a copper-foiled flexible base board for printed circuit board comprising the steps of:
   - subjecting one surface of a base plastic film having flexibility to a surface roughening treatment by honing using a liquid dispersion of an abrasive powder and,
   - coating said roughened surface with a copper foil and an intervening layer of an adhesive for adhesively and integrally bonding said copper-foil to said roughened surface with said adhesive layer therebetween.

2. A process as claimed in claim 1 wherein the conditions of the honing treatment are so controlled as to provide said roughened surface with microcavities each having a depth in the range from 1 to 5 μm and a width in the range from 0.5 to 2 μm at a half depth thereof.

**Patentansprüche**

1. Verfahren zur Herstellung einer mit einer Kupferfolie versehenen flexiblen Basisplatte für gedruckte Schaltungen mit folgenden Stufen:

— man unterwirft eine Oberfläche eines als Basis dienenden, flexiblen Kunststoffilms einer Oberflächenaufrauhbehandlung mittels Abziehen, wobei man eine flüssige Dispersion eines abrasiven Pulvers einsetzt und

— man bedeckt diese aufgerauhte Oberfläche mit einer Kupferfolie und einer dazwischenliegenden Schicht aus einem Klebstoff zur klebenden und integralen Verbindung dieser Kupferfolie über die dazwischenliegende Klebeschicht mit der aufgerauhten Oberfläche.

2. Verfahren nach Anspruch 1, worin man die Abziehbehandlung bei solchen Bedingungen durchführt, daß die aufgerauhte Oberfläche mit Mikrohohlräumen ausgestattet wird, die jeweils eine Tiefe von 1 bis 5 µm und auf der halben Tiefe davon eine Breite von 0,5 bis 2 µm besitzen.

**Revendications**

1. Procédé pour la préparation d'un support flexible muni de feuilles de cuivre pour plaquettes à circuits imprimées, comprenant les étapes consistant à:

— soumettre une face du film plastique de support à un traitement conférant une rugosité de surface par pierrage, au moyen d'une dispersion liquide d'une poudre abrasive, et

— revêtir ladite face rendue rugueuse d'une feuille de cuivre et d'une couche intermédiaire d'adhésif pour lier par adhérence et assembler intégralement ladite feuille de cuivre à ladite face rendue rugueuse, ladite couche d'adhésif étant comprise entre elles.

2. Procédé selon la revendication 1, dans lequel les conditions du traitement de pierrage sont ajustées de façon à ce que ladite surface rendue rugueuse soit munie de microcavités, ayant chacune une profondeur dans la gamme de 1 à 5 µm et une largeur dans la gamme de 0,5 à 2 µm, à la moitié de la profondeur de la cavité.